# EUROPÄISCHE PATENTSCHRIFT

(11) **EP 1 082 766 B1**
(45) Veröffentlichungstag und Bekanntmachung des Hinweises auf die Patenterteilung: **13.08.2003**
(21) Anmeldenummer: 99944141.3
(22) Anmeldetag: 30.03.1999
(51) Int. Cl.: H01L 39/02, H01L 39/24

(54) **IM HERSTELLUNGSPROZESS VON HOCHTEMPERATUR-SUPRALEITENDEN BANDLEITERN ANZUWENDENDES BESCHICHTUNGSVERFAHREN**
COATING METHOD FOR USE IN A PROCESS FOR PRODUCING HIGH-TEMPERATURE SUPRACONDUCTIVE STRIP CONDUCTORS
PROCEDE D'ENDUCTION UTILISABLE DANS LE PROCESSUS DE PRODUCTION DE LIGNES TRIPLAQUES SUPRACONDUCTRICES A HAUTE TEMPERATURE

(30) Priorität: 03.04.1998 DE 19815096
(43) Veröffentlichungstag der Anmeldung: 14.03.2001
(73) Patentinhaber: Vacuumschmelze GmbH & Co. KG, 63450 Hanau (DE); SASOL Germany GmbH, 22297 Hamburg (DE)
(72) Erfinder: MEYER, Arnold, D-25693 St. Michaelisdonn (DE); MÜLLER, Jens, D-42897 Remscheid (DE); FISCHER, Bernhard, D-63468 Bruchköbel (DE); KAUTZ, Stefan, D-90607 Rückersdorf (DE); ROAS, Bernhard, D-89520 Heidenheim (DE); HELLDÖRFER, Helmut, D-90411 Nürnberg (DE)
(74) Vertreter: Patentanwälte Westphal, Mussgnug & Partner
(86) Internationale Anmeldenummer: DE9900962
(87) Internationale Veröffentlichungsnummer: WO99052156

(56) Entgegenhaltungen:
- EP-A- 0 322 619
- EP-A- 0 803 917

## Beschreibung

Die vorliegende Erfindung bezieht sich auf ein Beschichtungsverfahren, das im Herstellungsprozeß von Hochtemperatursupraleitenden Bandleitern anzuwenden ist, die für Hochtemperatur-Supraleiterkabel benötigt werden.

Aus dem Stand der Technik
1) IEEE Trans. Appl. Supercond. Vol. 5, No. 2 (1995), p. 953 - 955
2) Funjikamik et. al. "5m/2 KA High-TC-Cable Conductor' Adv. in Superconductivity V,p. 1251 - 1254, Springer-Verlag 1993 (Konferenzberichte des 5th International Symposium on Superconductivity, 1992)
3) Sato et al. "Electromagnetic Properties and Structures of BiPbSrCaCuO Superconducting Wires", Advances in Superconductivity II, p. 335 - 340,
   Springer- Verlag, 1990
   (Konferenz-Bericht 2nd Int. Symp. on Superconductivity, 1989)
sind Hochtemperatur-Supraleiterkabel bekannt, die aus einer Vielzahl Bandleitern zusammengesetzt bestehen. Diese Bandleiter bestehen wiederum aus bekanntermaßen Hochtemperatur-Supraleitendem Keramikmaterial, wie z.B. (Bi,Pb)₂Sr₂Ca₂Cu₃Oₓ, das in vorzugsweise einer Silbermatrix enthalten ist. Diese Silber-Matrix-Bandleiter sind im fertigen Kabel z.B. verseilt auf einem Träger, z.B. einem Wellrohr, aufgebracht und an ihren Enden kontaktbildend gelötet.

Aus der EP0 044 144 B1 ist es bekannt, zur elektrischen Isolation der fadenförmigen supraleitenden Leiter aus intermetallischer Verbindung gegeneinander, damit sie als Magnetspule gewickelt werden können, diese Leiter mit einer isolierenden keramischen Außenschicht zu versehen. Diese Außenschicht wird auf den Leitern in situ erzeugt, indem eine wässrige Suspension aus Natriumsilikat, Kaolin und Kalziumkarbonat aufgebracht, getrocknet und oberhalb 500°C wärmebehandelt wird.

Aus der EP 0 322 619 A1 ist es bekannt, zwischen einem Träger aus z.B. Strontiumtitanat, aber auch aus einem Metall, und seiner Beschichtung mit einem oxidkeramischen Hochtemperatur-Supraleiterwerkstoff eine Schicht vorzusehen, die gute Haftung zwischen Träger und Beschichtung bewirkt und chemische Reaktionen und Wechselwirkungen zwischen Trägermaterial und dem oxidkeramischen Werkstoff verhindert. Für diese Zwischenschicht ist dort u.a. Aluminiumoxid vorgesehen, das als alkoholische Suspension auf der Trägeroberfläche aufgebracht wird und zwecks dauerhafter Verbindung mit dem Trägermaterial bei 950°C gesintert wird.

Diese Bandleiter werden im Herstellungsverfahren bei entsprechend hohen Temperaturen bekanntermaßen gesintert, wobei diese Bandleiter bzw. ein Teilstück dieses langgestreckten Bandleiters (einige 100 m) spiralförmig auf einer Glühunterlage gewickelt und aneinanderliegend geglüht werden. Um ein Aneinanderkleben bzw. Haften der Bandleiter während der dafür erforderlichen Glühprozesse zu vermeiden, ist auf einem jeden einzelnen Bandleiter eine Beschichtung aus vorzugsweise Aluminiumoxid vorgesehen. Diese Maßnahme gewährleistet, daß ein Aneinanderkleben/Haften der Einzellagen/Windungen dieses Bandleiters bei hohen Temperaturen von größer 800°C, bei denen die mechanische Belastbarkeit des Silbers gering ist, verhindert wird.

Zur Herstellung eines Supraleiterkabels müssen die fertig prozessierten Bandleiter einzeln verwickelt und an entsprechenden Anschlüssen kontaktiert werden. Bei der elektrischen Kontaktierung des jeweiligen Endes eines solchen Supraleiter-Kabels mit Anschlüssen ist ein Miteinander-Verlöten von Kabelende und Anschluß erforderlich. Dazu müssen die einzelnen Bandleiter zuverlässig mit dem Anschluß verlötet werden können. Dem steht jedoch die ansonsten erforderliche Aluminiumoxid-Beschichtung der Bandleiter im Wege. Es ist daher erforderlich, einen Lösungsweg zu haben, der diese an sich bestehende Unvereinbarkeit behebt.

Aus der EP 0803 917 A1 ist bekannt, eine Zwischenschicht aus Aluminiumoxid dadurch herzustellen, daß ein Teil des Aluminiums zur Grenzfläche zwischen Silber und Legierung diffundiert und dort oxidiert wird.

Aufgabe der vorliegenden Erfindung ist es, einen Lösungsweg anzugeben, der ein Haften der Bandleiter aneinander während des Glühens verhindert und ein Löten für spätere Kontaktierung der Bandleiter erleichtert.

Einen solchen Lösungsweg sowie Weiterbildungen und weitere Ausgestaltungen desselben geben der Patentanspruch 1 und die Unteransprüche an.

Die vorliegende Erfindung sieht bei einem Herstellungsverfahren von Bandleitern für das nachfolgende Löten zwecks Kontaktierung der Bandleiter vor, eine gezielte Auswahl bezüglich des zu verwendenden Aluminiumoxids für die an sich notwendige Beschichtung der Bandleiter zu treffen. Es wurde festgestellt, daß eine ganz entscheidende Erleichterung für das nachfolgende Löten dadurch zu erzielen ist, daß man für die Ausführung dieser Beschichtung ein Aluminiumoxid in wässriger Suspension anwendet, wobei die in dieser Suspension fein verteilt enthaltenen Aluminiumoxidpartikel eine Teilchengröße beschränkt auf etwa 0,5 bis etwa 10 µm haben. Vorzugsweise wird die Suspension so aufgetragen, daß sie (zunächst) zu einer Schichtdicke bis (maximal) etwa 10 µm auf dem Bandleiter führt. Die ausgewählte wässrige Suspension bringt man z.B. in einem Durchlaufverfahren auf dem Silbermatrix-Bandleiter auf. Dazu empfiehlt es sich darauf zu achten, daß auf der Bandleiteroberfläche keinerlei (Reste von) Lösungsmittel(n) vorhanden sind, die zur Reinigung verwendet werden (könnten). Dies würde nämlich die Oberflächenspannung hinsichtlich der Suspension so weit erhöhen, daß eine nahezu geschlossene Beschichtung mit der vorgesehenen Suspension nicht mehr möglich ist. Ebenfalls sind grobe Verunreinigungen der Silberoberfläche zu vermeiden.

Es kann auch vorgesehen sein, die mit der Suspension auf dem Bandleiter zu erzeugende Aluminiumoxid-Beschichtung so dünn herzustellen, daß diese porös ist. Eine solche Porosität kann insbesondere auch dazu dienen, mit dem nachträglich anzuwendenden Lot das Material des Bandleiters elektrisch direkt zu kontaktieren, ohne diese aufgebrachte Schicht vorher mechanisch zu beeinflussen.

Auch aus ökologischen Gründen ist es von Vorteil, erfindungsgemäß eine wässrige Suspension anzuwenden.

Die wie voranstehend beschriebene Suspension wird, auf der Oberfläche des jeweiligen Bandleiters aufgebracht und bei Temperaturen von mehr als 100°C, z.B. von ca. 600°C, in einem Durchlaufofen oder dgl. getrocknet.

Bevorzugt ist, Aluminiumoxid zu verwenden, das in den Tonerdepartikeln Kristallwasser enthält. Bei der beschriebenen Anwendung hoher Temperatur führt dies dazu, daß bei Temperaturen über 500°C ein Ausgasen des Kristallwassers stattfindet, was auch zu einer gewissen Porosität der fertigen Aluminiumoxidbeschichtung führen kann. Auch führt dies dazu, daß die Hafteigenschaften der Aluminiumoxidpartikel der Beschichtung auf der Silberoberfläche des Bandleiters erfindungsgemäß weniger fest ist und anschließend, nämlich für das nachfolgende Löten, aber auch zwischen den einzelnen Glühbehandlungen, durch eine mehrere Minuten andauernde Ultraschallbehandlung an der Lotstelle in einfacher Weise wieder entfernt werden kann.

Es kann von Vorteil sein, den Bandleiter, d.h. das Silber, vor dem Aufbringen der Suspension leicht aufzurauhen/anzurauhen. Nach Aufbringen/Herstellen der Beschichtung und vor dem Löten kann es von Vorteil sein, den jeweiligen Bandleiter an der Lotstelle mit Lösungsmitteln, Säuren oder ähnlichem, insbesondere mit Aceton, zu reinigen und das Lot direkt aufzubringen.

Es kann auch vorgesehen sein, den jeweiligen Bandleiter auf seiner gesamten Länge nach dem erfolgten Sintern desselben wieder wenigstens zu einem Anteil von der (nach dem Sinterprozeß des Bandleiters nicht mehr erforderlichen) Aluminiumoxidbeschichtung zu befreien. Dies nämlich dazu, um dann den Bandleiter in einem Durchlaufverfahren auf seine Eigenschaften hin untersuchen zu können und die Möglichkeit zu haben, seine mechanischen und/oder elektrischen Eigenschaften durch bekannte nachträgliche Eindiffusion von Fremdmetallen in das Silber noch verbessern bzw. egalisieren zu können.

Das nachfolgend beschriebene Fließbild soll eine Übersicht zum erfindungsgemäßen Verfahren geben. In der Stufe 1 erfolgt bekanntermaßen das Zusammenbringen, Pressen, Strangziehen und dgl. des noch nicht gesinterten Bandleiters in eine Silbermatrix. In der zweiten Stufe erfolgt das nach erfindungsgemäßer Auswahl des Aluminiumoxids und der Verfahrensparameter vorzunehmende Beschichten des Bandleiters mit der erfindungsgemäß wässrigen Aluminiumoxid-Suspension mit erfindungsgemäßer Partikelgröße.

In der dritten Stufe erfolgt das Eintrocknen der Suspension zur Herstellung der Feststoff-Beschichtung.

Die vierte Stufe sieht das mindestens einmalige, insbesondere aber auch mehrmalige Sintern des spiralförmig angeordneten Bandleiters bzw. der Bandleiterbündel vor.

Die fünfte Stufe betrifft das Freilegen der Bandleiterenden und Kontaktlöten der Bandleiter miteinander und bzw. mit dem Anschlußteil am Kabelende.

Während der vierten, d.h. nach den einzelnen Glühbehandlungen, als auch zwischen der vierten und fünften Stufe kann fakultativ gemäß einer Weiterbildung der Erfindung eine wie beschriebene Ultraschall-Behandlung der Bandleiterenden eingeschoben sein.

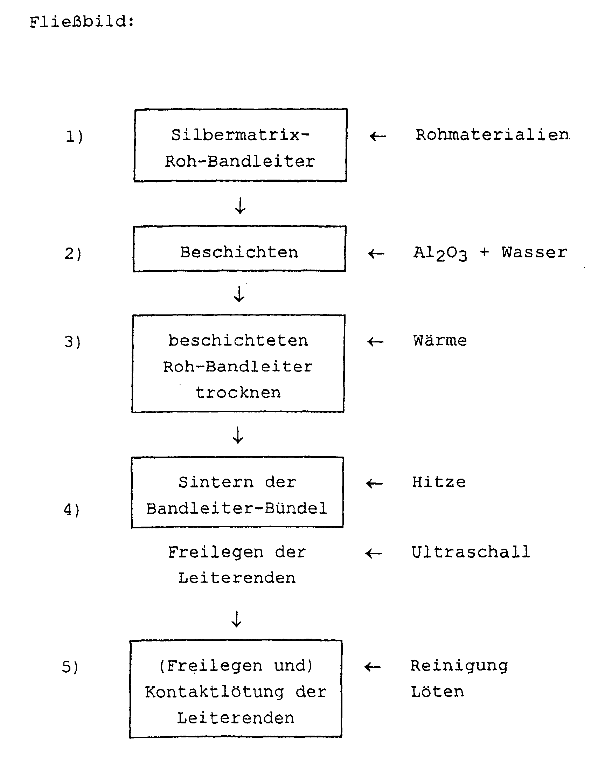

## Patentansprüche

1. Verfahren zur Herstellung von Hochtemperatur-Supraleiter-Silbermatrix-Bandleitern für Hochtemperatur-Supraleiterkabel mit einer wenigstens temporären Aluminiumoxid-Beschichtung, **dadurch gekennzeichnet, daß** Aluminiumoxid als wässrige Suspension fein verteilter Aluminiumoxidpartikel einer Teilchengröße von 0,5 bis 10 um in einer Schichtdicke bis 10 µm auf Bandleiter aufgebracht wird und die am Bandleiter anhaftende Suspension anschließend bei mehr als 100°C getrocknet wird.

2. Verfahren nach Anspruch 1, **dadurch gekennzeichnet, daß** das Trocknen im wesentlichen bei 600°C ausgeführt wird.

3. Verfahren nach Anspruch 1 oder 2, **dadurch gekennzeichnet, daß** vor dem Aufbringen der Suspension die zu beschichtenden Bandleiter unter Vermeidung der Anwendung von acetonischen oder alkoholischen Lösungsmitteln gereinigt werden.

4. Verfahren nach Anspruch 1, 2 oder 3, **dadurch gekennzeichnet, daß** vor dem Aufbringen der Suspension der jeweilige Bandleiter leicht angerauht wird.

5. Verfahren nach Anspruch 1, 2, 3 oder 4, **dadurch gekennzeichnet, daß** vor einem Löten an einer Lotstelle mit Lot der schon fertig beschichtete Bandleiter an der Lotstelle mit Lösungsmittel gereinigt und das Lot direkt auf diese Lotstelle aufgebracht wird.

6. Verfahren nach Anspruch 5, **dadurch gekennzeichnet, daß** als Lösungsmittel Aceton verwendet wird.

7. Verfahren nach Anspruch 1, 2, 3 oder 4, **dadurch gekennzeichnet, daß** vor Löten an einer Lotstelle mit Lot der schon fertig beschichtete Bandleiter an der Lotstelle mit Säure gereinigt und das Lot direkt auf diese Lotstelle aufgebracht wird.

8. Verfahren nach einem der Ansprüche 1 bis 7, **dadurch gekennzeichnet, daß** Aluminiumoxid in der Form von Kristallwasser enthaltenden Tonerdepartikeln verwendet wird und bei Temperaturen über 500°C das Kristallwasser aus der aufgebrachten Tonerde-Beschichtung ausgegast wird.

9. Verfahren nach einem der Ansprüche 1 bis 8, **dadurch gekennzeichnet, daß** die Beschichtung bei Temperaturen bis 900°C auf dem Bandleiter gesintert wird.

10. Verfahren nach einem der Ansprüche 1 bis 8, **dadurch gekennzeichnet, daß** die Beschichtung bei Temperaturen bis 820°C auf dem Bandleiter gesintert wird.

11. Verfahren nach einem der Ansprüche 1 bis 10, **dadurch gekennzeichnet, daß** zur Wiederbeseitigung wenigstens eines Anteils der Aluminiumoxid beschichtung des Bandleiters Ultraschall angewendet wird.

12. Verfahren nach Anspruch 11, **dadurch gekennzeichnet, daß** der Ultraschall zur Wiederbeseitigung an vorgesehenen Lotstellen angewendet wird.

13. Verfahren nach einem der Ansprüche 1 bis 11, **dadurch gekennzeichnet, daß** nach dem Sintern der das Supraleitermaterial enthaltenden Silbermatrix des Bandleiters die Beschichtung über den gesamten Bandleiter hinweg wieder entfernt wird.

14. Verfahren nach Anspruch 13, **dadurch gekennzeichnet, daß** nach dem Wiederentfernen der Beschichtung eine Eindiffusion von Fremdmetallen in das Material des Bandleiters vorgenommen wird.

15. Verfahren nach einem der Ansprüche 1 bis 10, **dadurch gekennzeichnet, daß** die Aluminiumoxid-Beschichtung so dünn hergestellt wird, daß sie derart porös ist, daß nachträglich anzuwendendes Lot das Material des Bandleiters ohne mechanische Bearbeitung direkt kontaktiert.

## Claims

1. Method of producing high-temperature superconducting silver-matrix strip conductors for high-temperature superconducting cables with an at least temporary aluminium oxide coating, **characterised in that** aluminium oxide in the form of an aqueous suspension of finely distributed aluminium oxide particles having a particle size of 0.5 to 10 µm is applied to strip conductors to a layer thickness of up to 10 µm and the suspension adhering to the strip conductor is then dried at temperatures in excess of 100°C.

2. Method according to claim 1, **characterised in that** drying is carried out essentially at temperatures of 600°C.

3. Method according to claim 1 or claim 2, **characterised in that**, prior to the application of the suspension, the strip conductors to be coated are cleaned, avoiding the use of acetone or alcoholic solvents.

4. Method according to claim 1, 2 or 3, **characterised in that** the respective strip conductor is slightly roughened prior to the application of the suspension.

5. Method according to claim 1, 2, 3 or 4, **characterised in that**, prior to soldering with solder at a soldering point, the already coated strip conductor is cleaned with solvent at the soldering point and the solder is applied directly to this soldering point.

6. Method according to claim 5, **characterised in that** acetone is used as the solvent.

7. Method according to claim 1, 2, 3 or 4, **characterised in that**, prior to soldering with solder at a soldering point, the already coated strip conductor is cleaned with acid at the soldering point and the solder is applied directly to this soldering point.

8. Method according to one of claims 1 to 7, **characterised in that** aluminium oxide in the form of alumina particles containing water of crystallisation is used and the water of crystallisation is exhausted from the alumina coating applied at temperatures in excess of 500°C.

9. Method according to one of claims 1 to 8, **characterised in that** the coating is sintered on the strip conductor at temperatures of up to 900°C.

10. Method according to one of claims 1 to 8, **characterised in that** the coating is sintered on the strip conductor at temperatures of up to 820°C.

11. Method according to one of claims 1 to 10, **characterised in that** ultrasound is used to remove at least part of the aluminium oxide coating from the strip conductor.

12. Method according to claim 11, **characterised in that** the ultrasound is used for removal at intended soldering points.

13. Method according to one of claims 1 to 11, **characterised in that**, after the sintering of the silver matrix of the strip conductor containing the superconducting material, the coating is removed from the entire strip conductor once again.

14. Method according to claim 13, **characterised in that**, after the removal of the coating, foreign metals are diffused into the material of the strip conductor.

15. Method according to one of claims 1 to 10, **characterised in that** the aluminium oxide coating produced is so thin that it is porous in such a manner that solder to be applied subsequently directly contacts the material of the strip conductor without machining.

## Revendications

1. Procédé de fabrication de rubans à matrice en argent supraconducteurs à haute température, destinés à des câbles supraconducteurs à haute température et portant au moins temporairement un revêtement en oxyde d'aluminium
**caractérisé en ce que**
l'oxyde d'aluminium, sous la forme d'une suspension aqueuse de particules d'oxyde d'aluminium finement divisées avec des dimensions allant de 0,5 à 10 microns, est déposé en une couche d'épaisseur allant jusqu'à 10 µm, sur les rubans conducteurs et la suspension adhérant à ces rubans est ensuite séchée à plus de 100° C.

2. Procédé selon la revendication 1,
**caractérisé en ce que**
le séchage a lieu essentiellement à 600° C.

3. Procédé selon la revendication 1 ou 2,
**caractérisé en ce qu'**
avant le dépôt de la suspension, les rubans conducteurs à revêtir sont nettoyés, en évitant d'utiliser des solvants à base d'acétone ou d'alcools.

4. Procédé selon la revendication 1, 2 ou 3,
**caractérisé en ce qu'**
avant le dépôt de la suspension, chaque ruban conducteur est rendu légèrement rugueux.

5. Procédé selon les revendications 1, 2, 3 ou 4,
**caractérisé en ce qu'**
avant brasage en un point avec de la brasure, le ruban conducteur déjà garni de son revêtement est nettoyé au point de brasage par des solvants, et la brasure est déposée directement en ce point.

6. Procédé selon la revendication 5,
**caractérisé en ce que**
le solvant utilisé est de l'acétone.

7. Procédé selon les revendications 1, 2, 3 ou 4,
**caractérisé en ce qu'**
avant brasage en un point avec de la brasure, le ruban conducteur déjà garni de son revêtement est nettoyé au point de brasage avec de l'acide et la brasure est déposée directement en ce point.

8. Procédé selon l'une des revendications 1 à 7,
**caractérisé en ce que**
l'oxyde d'aluminium est utilisé sous la forme d'alumine contenant de l'eau de cristallisation et celle-ci est éliminée du revêtement à base d'alumine qui a été déposé, par chauffage au-dessus de 500° C.

9. Procédé selon une des revendications 1 à 8,
**caractérisé en ce que**
le revêtement est fritté sur le ruban conducteur, à des températures allant jusqu'à 900° C.

10. Procédé selon une des revendications 1 à 8,
**caractérisé en ce que**
le revêtement est fritté sur le ruban conducteur, à des températures allant jusqu'à 820° C.

11. Procédé selon une des revendications 1 à 10,
**caractérisé en ce que**
pour éliminer à nouveau une partie du revêtement en oxyde d'aluminium, des ultrasons sont utilisés.

12. Procédé selon la revendication 11,
**caractérisé en ce que**
les ultrasons sont utilisés en des points de brasage prévus.

13. Procédé selon une des revendications 1 à 11,
**caractérisé en ce qu'**
après frittage de la matrice d'argent contenant le matériau supraconducteur, le revêtement du ruban conducteur est retiré sur toute la surface de celui-ci.

14. Procédé selon la revendication 13,
**caractérisé en ce qu'**
après que le revêtement ait été retiré, il est effectué une diffusion de métaux étrangers dans le matériau du ruban conducteur.

15. Procédé selon une des revendications 1 à 10,
**caractérisé en ce que**
le revêtement ou oxyde d'aluminium est réalisé suffisamment fin pour être poreux au point que la brasure à utiliser ensuite établit un contact directement sans usinage mécanique préalable.
